# EUROPEAN PATENT APPLICATION

(11) **EP 4 664 507 A1**
(43) Date of publication of application: **17.12.2025**
(21) Application number: 24181354.2
(22) Date of filing: 11.06.2024
(51) Int. Cl.: H01L 21/268, H01L 23/48, H01L 21/78

(54) **WAFER AND DIE SHAPE CONTROL**

(71) Applicant: Carl Zeiss SMS Ltd., 2015600 Misgav (IL)
(72) Inventor: GORHAD, Kujan, 2015600 Misgav (IL)
(74) Representative: Bardehle Pagenberg Partnerschaft mbB Patentanwälte Rechtsanwälte

(57) **Abstract**

A method for adjusting a shape of a wafer and/or die having a substrate and at least one surface layer comprises applying a plurality of local modifications in the wafer and/or die, wherein applying the plurality of local modifications comprises applying a plurality of local modifications within the at least one surface layer and/or applying a plurality of local modifications within the substrate, via the at least one surface layer.

## Description

### 1. Technical field

The present invention relates to controlling a shape of a wafer and/or a die. In particular, the invention relates to a method for adjusting a shape of a wafer having a substrate and at least one surface layer, a method for conditioning dies for bonding, as well as corresponding chips, apparatuses, and computer programs.

### 2. Prior art

In the field of semiconductor technology, various methods and devices for processing wafers are known. For example, the wafer may comprise a (semiconductor-based) substrate wherein the processing thereof may enable the manufacturing of one or more chips. Usually, such a manufacturing of chips may require a complex integration of a plurality of processing steps applied to the substrate. For example, a processing step may comprise a material deposition onto the substrate, an etching of the substrate and/or deposited material, an oxidation of the substrate, a lithographic patterning on the substrate, etc. For example, a processing step may also comprise bonding the wafer to another wafer (e.g., wafer to wafer bonding), or to one or more dies (wafer to die bonding). The processed wafers and/or dies may form a chip.

A processing of a wafer may be usually engineered to cause a specified outcome (e.g., a specified material deposition height, a specified etching depth, a specified lithographic overlay etc.). However, a processing can also lead to an undesired property being induced onto the wafer and/or substrate. The undesired property may in turn negatively impact further processing. Notably, the undesired property may already be present in the substrate without being induced by a particular processing thereof (e.g., the unprocessed semiconductor base material of a wafer may already comprise the undesired property). In some cases, the root cause for the undesired property may even be unknown.

To that regard, many types of undesired properties of a wafer can be possible. For example, the undesired property may comprise an undesired mechanical property of the wafer. This may comprise an undesired bending, an undesired shape and/or undesired mechanical stress being present, etc. Other types of undesired properties may, for example, comprise an undesired defect and/or an undesired surface property (e.g., an undesired surface roughness, an undesired discoloration, an undesired surface energy, an undesired distortion, e.g., including a structed pattern on the substrate, etc.).

It can therefore be necessary to condition a wafer and/or its substrate via a conditioning step to minimize or substantially remove the impact of the undesired property of the substrate. The conditioning may optimize and/or even be of high relevance to enable a defined processing of the wafer.

To that regard various types of conditioning of substrates are known in the semiconductor technology field.

For example, a conditioning of a substrate may comprise a substrate clean (e.g., a chemical clean and/or a plasma treatment) and/or the application of a thermal treatment to a substrate for a conditioning thereof. It is also known to apply a chemical mechanical polishing (CMP) process to a substrate as a conditioning thereof for further processing.

However, the currently known techniques for conditioning are not always optimal, particularly when it comes to wafer to wafer or wafer to die bonding. Therefore, there is a need to find ways to improve conditioning.

### 3. Summary of the invention

The aspects described herein address the above need at least in part.

A **first aspect** relates to a method for adjusting a shape of a wafer and/or die having a substrate and at least one surface layer. The method comprises applying a plurality of local modifications within the wafer and/or die. The applying the plurality of local modifications comprises: applying a plurality of local modifications within the at least one surface layer; and/or applying a plurality of local modifications within the substrate, via the at least one surface layer.

By applying a plurality of local modifications within the surface layer and/or via the surface layer, the adjustment of the shape can occur later in the fabrication process. Influences on the shape of the wafer and/or die by depositing, doping or otherwise processing the substrate to generate the at least one surface layer may thus be compensated by the local modifications that are applied either within the at least one surface layer or via the at least one surface layer, or both. For example, deposition of layers may lead to a deformation of a substrate, e.g. by stresses or strains within the deposited layer, such that the wafer and/or die may be provided with a shape that deviates from an optimum shape. By means of the local modifications, these deviations may be reduced or eliminated. This idea of the inventors has specifically overcome the common prejudice that applying local modifications in processed wafers and/or dies could harm process structures of the wafer and/or die, such that local modifications should be applied only to a bare substrate. In contrast, to this prejudice, according to the first aspect described herein, a processed wafer and/or die can be shape-controlled, e.g. by local modifications within one or more surface layers or local modifications generated via the one or more surface layers.

Particularly, applying the local modifications within the at least one surface layer may be particularly advantageous, as this can practically exclude that sensitive process structures within the substrate may be affected by the local modifications. Also, while substrates (e.g. Ai, GaAs, etc.) are often crystalline, surface layers are typically amorphous. Thus, applying, e.g. laser pulses to generate the local modifications will typically isotropically modify the stress/strain, e.g. following the (3-dimensional) intensity of the focus of laser pulses, whereas in crystals, this effect is usually non-isotropic. Hence, a certain stress/strain distribution and thus local and/or global deformations and/or displacements may be simpler to achieve in amorphous materials since the orientation of the crystal axes do not have to be taken into account.

Also, applying local modifications within the substrate as well as within the at least one surface layer provides two degrees of freedom, such that a desired 3-dimensional shape can be obtained particularly flexibly and precisely.

It is noted that in other examples, the aspects described herein may generally also be used with layers other than surface layers, e.g. buried layers within a substrate etc., or even without layers, but e.g., with other process structures on the wafer and/or die which may not form layers.

The substrate may comprise silicon. Adjusting the method to silicon may allow broad applicability to a wide range of wafers and/or dies.

The at least one surface layer may comprise silicon, in particular SiOₓ. Adjusting the method to these materials may allow broad applicability to a wide range of wafers and/or dies. Also, using silicon in the at least one surface layer may allow a particularly seamless application of the method for silicon substrates, as the generation of the local modifications, e.g. by laser pulses focused to an appropriate depth, may have similar properties in a silicon substrate and a silicon, e.g. SiOₓ, containing layer.

The at least one surface layer may be arranged at a backside of the wafer and/or die. Hence, for example process structures at a frontside of the wafer and/or die may remain unaffected by the local modifications applied within the at least one surface layer and/or via the at least one surface layer. The process for generating the local modifications, e.g. by applying laser pulses, does not affect the frontside, e.g. laser pulses do not need to penetrate the frontside, but instead they are applied at or via the backside.

For example, the at least one surface layer may be generally arranged at a side of the wafer and/or die that is opposite to a patterned side of the wafer and/or die.

For example, the wafer and/or die may comprise one or more desired process structures. The method for adjusting the shape may be applied after these process structures have been fabricated allowing a final shape control of the wafer and/or die.

Notably, the term shape may refer to a 3-dimensional contour of a surface of a frontside and/or a backside.

In some examples, the applying a plurality of local modifications within the at least one surface layer comprises applying a plurality of local modifications within at least one surface layer comprising a thickness of at least 8 µm and of at most 250 µm, preferably of at most 100 µm.

For typical substrates, a certain minimum size of the local modifications is beneficial to ensure a sufficient degree of shape control. Hence, a corresponding minimum thickness of the at least one surface layer is required to accommodate the minimum size. For typical substrate thicknesses and mechanical properties (e.g., of a crystalline silicon substrate of a thickness of about 700 µm to 800 µm thickness), the mentioned ranges have proven as suitable to achieve a sufficient amount of bending.

In some examples, the plurality of local modifications is adapted for rendering the wafer and/or die substantially flat. For example, the 3-dimensional shape of the wafer and/or die before applying the local modifications may be measured. Based thereon, local modifications are applied to modify the 3-dimensional shape to be substantially flat. This may be useful for further processing steps of the wafer and/or die, such as (3D-)lithography, wafer and/or die bonding, etc.

The plurality of modifications may be adapted for facilitating bonding the wafer and/or die to a further wafer and/or die. For example, the shape of the wafer and/or die may be rendered substantially flat, or any other 3-dimensional shape considered to be useful for bonding. For example, it may be adapted to the 3-dimensional shape of the further wafer and/or die, it may be rendered concave such as to enable a "rolling-on" type of bonding, etc.

**Another aspect** is directed to a method for conditioning dies for bonding. The method may comprise providing at least one die on at least one carrier. The method may further comprise applying a plurality of local modifications for facilitating bonding the at least one die to a wafer. The applying the plurality of local modifications may comprise: applying a plurality of local modifications within the at least one die; and/or applying a plurality of local modifications within the at least one carrier.

This aspect comprises the idea that wafer to die bonding can be improved by conditioning the die and/or its carrier (e.g., instead of conditioning the wafer). The conditioning is implemented via defined local modifications within the die and/or its carrier. For example, a shape of the die may be controlled by the local modifications.

Generally, the application of local modifications to dies and/or wafers may be considered a contrary approach to conventional conditioning processes which apply modifications onto an outer surface of an element. To that regard, a conventional conditioning process may comprise a defined physical and/or chemical interaction with a surface. However, in such common approaches a modification may not be applied within the wafer, the die and/or within its carrier in a defined manner. For example, common conditioning steps in the semiconductor industry may comprise a chemical wet clean, a plasma treatment and/or a chemical mechanical polishing (CMP). Such common conditioning methods may be solely based on a defined chemical and/or physical interaction with the surface. For example, the interaction with the surface may comprise a liquid disposed over the surface (e.g., for a wet clean conditioning), a plasma cloud interacting with the surface (e.g., for a plasma treatment conditioning), and/or a mechanical force being applied onto the surface (e.g., for a CMP process).

Furthermore, in common conditioning approaches it may rather be the case that a global modification is applied. For example, common conditioning processes such as a chemical wet clean, a plasma treatment, a CMP process and/or a thermal treatment may be considered as applying a global modification, e.g., to a substrate. Namely, in these common conditioning approaches the defined physical and/or chemical interaction of the conditioning may only occur globally with respect to the entire substrate (e.g., the entire substrate surface). For example, the global interaction may comprise treating the entire substrate's surface in a substantially homogenous manner for conditioning (e.g., as is the case in a wet clean, a plasma treatment, a CMP process as stated above). The global interaction may also comprise a thermal treatment comprising a heating or cooling of the entire substrate in a substantially homogenous manner for a conditioning thereof (e.g., in a furnace or in a cryogenic chamber). Hence, in such common conditioning processes the defined physical and/or chemical interaction may not be localized such that it may not be possible to apply a plurality of local modifications to the substrate, let alone in a defined manner.

The common approaches for conditioning may not always lead to optimal results. For example, common approaches may have a limited conditioning effect wherein a reduction or a substantial elimination of an undesired property of the substrate may not always be possible in a defined manner. Furthermore, common conditioning approaches may not always be suitable and/or customizable in view of a specific processing and/or an (specific) characteristic of the substrate.

Apart from that, the inventors have found out that applying a plurality of local modifications within a die may greatly improve die bonding. For example, individual dies may be processed, and e.g. provided with a suitable 3-dimensional shape, individually for improving bonding, e.g. independent from other areas of a wafer. For example, a die may be individually flattened or provided with a concave shape, as desired.

Also, the inventors have found out that a control of die conditioning, e.g., of a die 3-dimensional shape, may also be enabled by applying the local modifications into a carrier. This may leave the internal structure of the die completely unaffected but still provide the desired conditioning (e.g. 3-dimensional shape) for bonding, e.g. via stresses transferred from the carrier to the die. Also, since carriers may typically have an amorphous structure, they may be particularly easy to control, e.g. as outlined with reference to surface layers.

In particular, applying local modifications within the die as well as within the carrier provides two degrees of freedom, such that a desired 3-dimensional shape can be obtained particularly flexibly and precisely.

Generally, each local modification of the plurality of local modifications may be separately adjustable such that a highly customized and/or flexible conditioning and/or shape-adjustment may occur.

Notably, the inventors have found out that the conditioning of the die may, for example, be highly suitable for facilitating a bonding to a wafer. As the bonding usually comprises a highly complex joining process, an undesired property (e.g., an undesired mechanical property and/or an undesired surface property) of a die may easily lead to a poor bonding quality (e.g., at least one bonding parameter being adversely affected) or even to a completely failed bonding process.

The insight of the inventors that a plurality of modifications may be applied within a wafer and/or a die was contrary to a common prejudice, as already briefly outlined above. Namely, in the semiconductor technology field a plurality of local modifications within a wafer or die may usually be associated with crystallographic defects that may have one or more adverse effects on the physical characteristics (e.g., a higher mechanical stress, an irregular crystal quality, resulting surface defects, etc.). Hence, local modifications within the substrate (e.g., defects within the substrate) may usually be regarded as detrimental for a bonding. It is thus, for example, very common to actively minimize or eliminate local modifications for facilitating a specific processing of the substrate (e.g., a bonding thereof). For example, a crystal growth or an epitaxial process for generating the underlying substrate is usually engineered to actively minimize crystal defects within the substrate to facilitate a specific (subsequent) processing of the substrate. However, the inventors have found out that actively applying defined local modification (e.g., in a predefined manner) within the wafer and/or die may facilitate bonding and/or shape control in general.

Generally, a local modification may comprise a defined local deviation (e.g., a defined local perturbation) that was not present before the applying of the plurality of local modifications occurred. Notably, a defined local modification may be considered a (spatially delimited) pixel which is applied within the respective material. For example, the pixel may be spatially delimited within a local area and/or local volume.

In an example, the local deviation may comprise a defined local mechanical deviation. For example, the defined local mechanical deviation may comprise a local density variation. The local mechanical deviation may, for example, comprise a (spatially delimited) pixel having a different density than a surrounding material.

In an example, the defined local mechanical deviation may comprise a local stress element which may induce a local stress within the substrate. The local stress element may comprise an element that can induce a strain (e.g., a predefined strain) along one or more axes of the substrate. For example, the local stress element may be adapted to induce a predetermined first force along a first axis within the material and a predetermined second force along a second axis within the material. For example, the magnitude of the first force may be different from the magnitude of the second force. It may also be conceivable that the magnitude of the first force substantially corresponds to the magnitude of the second force. In an example, the first axis may be orthogonal to the second axis. In another example, the first axis and the second axis may span an angle different than 90°. In an example, the local density variation of the pixel may comprise an elliptical shape (e.g., an ellipsoid form) and/or a circular shape (e.g., a spherical form). In an example, the local stress element may comprise an alignment (e.g., a pixel alignment). The alignment may comprise the orientation of the first force vector (and/or the second force vector) of the local stress element with respect to a reference orientation. For example, a pixel alignment (e.g., a force vector) may be tilted in a certain angle with respect to the reference orientation. In an example, the alignment may comprise an orientation of a characteristic axis of the local density variation of the pixel (e.g., an orientation of a longer axis of the local density variation, e.g., an elliptical axis, if the local deformation comprises the shape of an ellipse). In an example, the local stress element may comprise (or be referred to as) a micro strain element.

In an example, the local modification (as described herein) may be a persistent local modification. Hence, the local modification may persist over a prolonged period of time. Notably, the extent of the persistent local modifications may change over time. For example, the extent of the strain and/or the magnitude of the (mechanical) force induced within the substrate via the local modification may reduce over time. However, the local modification may persist to such an extent that the presence of the persistent local modification within the substrate may be verified over a prolonged period of time (e.g., after 1 day, after 1 week, after 1 month, after 1 year, after 10 years, after 20 years, etc.).

Notably, a local modification (as described herein) may induce a local optical deviation. The local optical deviation may comprise a deviation in a refractive index and/or an absorption coefficient within an effective optical area around and/or within the local modification. For example, a presence of a local modification may thus be verified via an optical analysis (e.g., via an optical measurement, e.g., a microscope).

Notably, in some common approaches, the conditioning may not persist over a prolonged period of time (e.g., only over a period of several hours, or several days). Therefore, common approaches may require that the further processing of the substrate may need to be implemented in an according time window after conditioning. This may require a complex time coupling management (e.g., in a semiconductor factory) for the processing of the substrates. However, the inventors have found out that by applying local persistent modifications within the substrate such drawbacks may be alleviated as the conditioning effect may persist over a prolonged period of time.

In an example, the applying of the plurality of local modifications may comprise generating a defined arrangement (e.g., an array, a matrix) of the plurality of local modifications within the wafer, layer, die, and/or its carrier. The defined arrangement may be defined via one or more arrangement parameters which may be adaptable to enable a conditioning with a higher degree of freedom in a customizable/flexible manner compared to common approaches. In such examples, the local modifications may substantially extend across the entire wafer/layer/die/carrier or at least substantial portions thereof. Correspondingly, a quasi-global modification may be achieved.

For example, an arrangement parameter may comprise an arrangement pattern of the plurality of modifications. For example, the arrangement pattern may comprise a rectangular pattern wherein the modifications are arranged such that an envelope of the modifications substantially resembles a rectangular shape. The arrangement pattern may also comprise a circular pattern wherein the modifications are arranged such that an envelope of the modifications substantially resembles a circular shape. However, any other geometric pattern of the arrangement may also be conceivable (e.g., an elliptic pattern, a polygon pattern, etc.). For example, for a specific bonding process it may be necessary to implement a particular pattern of modifications for an effective conditioning.

In an example, an arrangement parameter may comprise a number of modifications which are present in the plurality of local modifications. Hence, the number of modifications within the substrate may be adaptable to enable a conditioning of the sample (e.g., substrate, surface, layer, die, and/or die carrier) in a customizable manner (e.g., in view of a bonding to a wafer). For example, for a specific bonding process (e.g., to a specific target wafer) it may be necessary to implement a certain number of modifications within the sample to enable an effective conditioning.

In an example, an arrangement parameter may also comprise a spacing distance between modifications of the plurality of local modifications. The spacing distance may comprise a (lateral or vertical) distance from a center of a first modification to a center of an adjacent second modification of the plurality of local modifications. Hence, the spacing between the local modifications may be adaptable to enable a conditioning in a customizable manner (e.g., in view of a bonding). For example, for a specific bonding process (e.g., to a specific target wafer) it may be necessary to implement a certain (lateral or vertical) spacing distance within the substrate, surface layer, die, and/or die carrier for an effective conditioning. The spacing distance may be a distance between 1 mm and 100 mm, preferably between 2 mm and 50 mm, more preferably between 5 mm and 20 mm, most preferably between 8 mm and 15 mm. For example, the spacing distance may be 10 mm. In an example, the spacing distance may be considered a lateral resolution of the pixel grid (as described herein). In other examples, a vertical spacing distance may be between 1 µm and 800 µm, e.g. between 2 µm and 400 µm, for example. In an example, the spacing distance may be considered a vertical resolution of the pixel grid (as described herein).

In an example, an arrangement parameter may comprise a spatial order of the plurality of local modifications. For example, the plurality of local modifications may be positioned substantially along a two-dimensional plane.

In another example, the plurality of local modifications may be positioned substantially along two or more two-dimensional planes. Hence, the plurality of local modifications may be positioned in a three-dimensional arrangement (e.g., a first plane having a first number of modifications and a second plane having a second number of modifications wherein the first and second plane are spaced apart by a (predetermined) spacing distance).

Furthermore, the applying of the plurality of local modifications may comprise that a first local modification of the plurality of local modification comprises a first local modification parameter, wherein a second local modification of the plurality of local modifications may comprise a second local modification parameter which is different from the first local modification parameter. As described herein, a local modification (e.g., also referred to as pixel) may induce one or more forces along one or more axes within the substrate. The characteristics of the locally induced (mechanical) forces may be adaptable for each modification (e.g., for each pixel) of the plurality of modifications.

Hence, the plurality of local modifications may be considered a pixel grid wherein each pixel may adopt a variety of states. Hence, a highly customizable conditioning in view of a bonding or shape control may occur. To illustrate an example, a pixel may comprise an (adaptable) first force vector along a first force axis, and an (adaptable) second force vector along a second force axis, wherein the first axis may be orthogonal to the second axis. Hence, a local modification parameter of a pixel may, for example, comprise an alignment of the pixel (with respect to a reference orientation), a magnitude of the first force and/or a magnitude of the second force (as described herein). Hence, every pixel may generate a defined three-dimensional, two-dimensional and/or one-dimensional mechanical effect that may be used to locally and/or globally conditioning and/or shape-control in a highly customizable manner. In another example, a local modification parameter may comprise a position of the pixel within the sample. For example, the position may be defined via coordinates along a plane for a predetermined depth. The position may also comprise a three-dimensional designation of pixel coordinates (e.g., a position may be defined via a cartesian coordinate system, e.g., via x-, y-, z- coordinates, and/or any other suitable coordinate system). The coordinate may, for example, address the position of the center of the pixel.

In an example, the applying of the plurality of local modifications may be based at least in part on a trigger (e.g., an information) for bonding. This may enable an automized approach to implement the method. For example, the method may comprise receiving a trigger that the wafer and/or die is for bonding. Based thereon, a predetermined recipe of the method may be activated to perform a method according to the aspects described herein. Notably, the method may also be implemented manually (e.g., an operator may initiate the applying of the plurality of the local modifications in view of an information, e.g., a visual/acoustical alert, for bonding).

In some examples, the applying a plurality of local modifications within the at least one die comprises applying a plurality of local modifications via a backside of the at least one die. Applying the local modifications via the backside may allow a gentle introduction of the local modifications without the need to work close to process structures on or at a frontside of the die.

For example, the local modifications may be applied via the backside of the die, e.g. by applying laser pulses to the backside of the die, for example, after dicing on a carrier. At this stage, the backside of the die may be exposed or at most be covered by a relatively thin surface layer, e.g. a protective layer, of limited thickness, such as 100 µm or less. Hence, there may be easy access to apply the local modifications within the die, e.g. within its substrate or within its surface layer. As regards the introduction to the surface layer, the aspects described herein with reference to surface layers of wafers may be used as well.

The applying a plurality of local modifications via a backside of the at least one die may comprise applying a plurality of local modifications via the at least one carrier. This application may be done after dicing and after picking up the die and attaching it to a carrier in an inverted way, i.e. with its backside facing the carrier. For example, laser pulses may be applied onto a surface of the carrier in a way such that they propagate through the carrier and into the die. Applying the local modifications at this stage (i.e. to the inverted dies) may be beneficial since the die is typically bonded to a wafer immediately after that stage. This may allow a particularly precise and reliable control of the die (3-dimensional) shape of the die that will remain in place until the actual bonding occurs without having to take into account potential effects of further processing steps, such as laser debonding, die pick-up, and die placement.

In some examples the at least one carrier comprises at least one of: a glass-based carrier, a quartz-based carrier, a silicon-based carrier, an adhesive layer.

The plurality of local modifications may generally be adapted such that the at least one die forms a substantially convex surface for facilitating bonding the at least one die to the wafer. This may facilitate a "rolling-on" type of bonding, etc. This may facilitate avoiding the creation of voids between wafer and die during the bonding process.

In some examples the plurality of local modifications is adapted such that at least one bonding quality parameter is improved compared to when no modifications are applied.

It is noted that a die may generally be understood as comprising a semiconducting material with one or more process structures that form one or more circuits. A die may be cut from a corresponding wafer.

Generally, the aspects described herein with respect to a wafer may also be applied to a corresponding die, e.g., a die cut from the corresponding wafer. Similarly, the aspects described herein with respect to a wafer may also be applied to more complex semiconductor elements such as wafer packages, chips, etc., as long as they comprise the corresponding elements outlined herein, such as a substrate and one or more surface layers.

In an example, the applying of the plurality of local modifications (e.g. to a wafer and/or die) may be based at least in part on a characteristic of a target wafer to which the wafer and/or die is to be bonded to. For example, the plurality of local modifications may be predetermined and/or customizable in view of a characteristic of the wafer and/or die, and/or the target wafer to which they are to be bonded to. The characteristic may comprise a geometric property, e.g. a 3-dimensional shape or a geometry as generally described herein.

For example, the wafer and/or die may be purposefully conditioned in view of a geometric property of the target wafer. Common conditioning approaches instead typically apply conditioning (e.g., via a wet clean, a plasma treatment) in a constant and/or steady manner with the same process parameters being applied for conditioning (e.g., the same cleaning chemistry, the same plasma parameters (such as plasma pressure)). In such common global conditioning examples, the conditioning may not be adapted (or even adaptable) in view of a characteristic of a particular die, substrate, or wafer.

In an example, the method may comprise determining the characteristic of the wafer, die and/or target wafer (e.g., via a measurement). In an example, the method may comprise receiving the characteristic (e.g., via a wireless or wire-based data link). In an example, the method may comprise determining and/or measuring the characteristic of the wafer, die and/or target wafer.

In an example of the method, the wafer and/or die may comprise one or more desired process structures.

A desired process structure may comprise a purposefully manufactured structure. For example, the desired process structure may be structured via one or more semiconductor manufacturing processes, as known in the field of semiconductor technology. The desired process structure may, for example, be at the surface of the substrate, the wafer, and/or the die. The desired process structure may be manufactured to have a defined desired geometry. It may thus be identified as an object with certain spatial dimensions. For example, the manufacturing of the desired process structure may be based on one or more lithographic processes. The manufacturing of the desired process structure may also be based on one or more etching processes. The desired process structure may also be manufactured to have one or more desired materials. For example, the manufacturing of the desired process structure may be based on or more material processes (e.g., material deposition, oxidation, implantation). In an example, the desired process structure may be an etched structure merely etched into the material of the substrate, the wafer, and/or the die. In a further example, the desired process structure may be a more complex structure. For example, the desired process structure may have at least one material that is different from the material of the substrate. For example, the desired process structure may comprise a metal. The metal may stem from an according deposition process. In an example, the desired process structure may comprise a semiconductor (e.g., a purposefully doped semiconductor). For example, the purposefully doped semiconductor of the desired process structure may stem from a semiconductor deposition process and/or an implantation process of the substrate. Also, the desired process structure may comprise an isolator (e.g., a purposefully manufactured isolator or dielectric) stemming from an according manufacturing process. The isolator may, for example, comprise an oxide or a dielectric in general. In an example, the desired process structure may comprise a resist structure. In an example the resist structure may be filled with a dielectric.

The desired process structure may also be termed as a semiconductor structure, as understood in the field of semiconductor technology. For example, the semiconductor structure may comprise a semiconductor device (e.g., a circuit, a transistor, a diode, a capacitor, a resistor, etc.). The semiconductor structure may also comprise a preform of a semiconductor device.

The desired process structure may also comprise an alignment structure (e.g., alignment marks) or a verification structure (e.g., a test structure).

In an example, the wafer and/or the die, as well as the target wafer may be structured. To that regard, the method may thus not be regarded as a simple conditioning of unstructured elements. Rather, the method may be used to condition a bonding wherein both bonding partners comprise structured elements. This may require a more sophisticated control of the characteristics of the plurality of local modifications (as described herein) to account for the reliable functionality of the already present desired process structures after bonding.

In an example, the applying of the plurality of local modifications may evoke a first target geometry (e.g. 3-dimensional shape). For example, the wafer and/or die may initially comprise an original geometry. By applying the plurality of local modifications the wafer and/or die may undergo a change from the original geometry to the first target geometry.

For example, the first target geometry may relate to a global and/or local target geometry. For example, the applying of the plurality of local modifications may induce a global change for the entire wafer and/or die such that a global target geometry is evoked. The target geometry may, e.g. in case of a plurality of dies on a carrier, also related to an interpolated geometry that include the surfaces of several dies.

In another example, the applying of the plurality of local modifications may induce a local change within a partial area and/or partial volume of the wafer and/or die. The remaining parts of the wafer/die may (in this case) not be significantly altered in their geometry.

In an example, the first target geometry may comprise a substantially flat geometry. A substantially flat geometry may comprise a comparatively low bow and/or warpage (e.g., in the same range as a base material of a substrate). The local modifications may thus also be used to create a substantially ideal flat geometry of the wafer and/or die.

In an example, the methods may comprise determining the plurality of local modifications based at least in part on an initial geometry of the wafer and/or die, and a first target geometry of the wafer and/or die, respectively. Additionally or alternatively, the determining may be based on a geometry of a target wafer to which the wafer and/or die is to be bonded to.

In an example, the methods comprise determining the first target geometry (e.g., which may also be referred to as deriving the first target geometry). For example, the first target geometry may be based on a simulation and/or a calculation (e.g., based on a geometry of the target wafer as described herein). In an example, the method may comprise determining the plurality of local modifications to evoke the first target geometry, e.g., when starting from the initial geometry. For example, the determining may comprise determining what local modification parameters the pixels (of the plurality of local modifications) should have to evoke the first target geometry. The determining of the plurality of local modifications may (also) be based on a simulation which may for example comprise a simulation model wherein the local modifications (e.g., pixels) may be applied to the simulation model to determine what geometry will be evoked. The desired first target geometry (and/or the local modification parameters of the pixels) may, for example, be determined in an iterative manner within the simulation.

In an example, the first target geometry may be predetermined such that at least one bonding quality parameter is improved compared to when no conditioning occurs. Hence, the invention may be used to improve the bonding quality. For example, the at least one bonding quality parameter may comprise at least one of the following: a yield of the bonding process, a bond strength, a defect density induced by the bonding, a bond interface quality. In the semiconductor technology field, such bonding quality parameters may be determined in a quantitative manner, for example, for process control purposes.

In an example, the method may comprise determining the first target geometry such that at least one bonding quality parameter is improved compared to when no conditioning occurs. The determining may be based on a simulation and/or a calculation (as described herein). Notably, also the bonding itself (e.g., its physical and/or chemical stress) may be simulated to determine an optimum first target geometry (e.g., such that the physical and/or chemical stress is minimized during bonding compared to when no conditioning occurs).

In an example, the first target geometry may be based at least in part on a predetermined geometry of the target wafer. The predetermined geometry may comprise a measurement of a geometry of the target wafer. In an example, the method may comprise determining the geometry of the target wafer (e.g., via a measurement). In an example, the method may comprise receiving the predetermined geometry of the target wafer (e.g., via a wireless or wire-based data link).

In an example, the predetermined geometry of the target wafer and/or die may comprise a global geometry. The global geometry may comprise a geometry that is substantially associated with an entire surface (e.g., a front surface, a back surface and/or a side surface) and/or an entire volume (e.g., a sample's three-dimensional characteristics).

In an example, the global geometry may comprise a surface topography and/or one or more deviations of the target wafer from a reference plane. For example, the surface topography may comprise a surface topography acquired via an optical topography measurement of the front and/or back surface. The surface topography may also comprise a surface topography acquired via a profilometric measurement of the front and/or back surface.

The one or more deviations from a reference plane may comprise at least one of the following: a bow, a warp and/or a total thickness variation (TTV). In the semiconductor field such deviations from an according reference plane are well known and may be determined in a quantified manner.

In an example, the global geometry may comprise a deviation map indicating a deviation (e.g., a spatial deviation) for two or more positions with respect to an according reference plane of the respective sample. The deviation map may, for example, be used as a starting point to determine a bow, a warp and/or a total thickness variation (as mentioned herein). However, the deviation map (e.g., its data points), may also be used as such to adapt the applying of the plurality of local modifications.

In an example, the global geometry may comprise a signature of the deviation map. For example, it may be predetermined that the deviation map of the target wafer may comprise one or more specific signature deviations since certain types of bending may occur. For example, a signature of the deviation map may comprise a saddle surface, a convex surface, a concave surface and/or any other characteristic surface shape of the deviation map.

In an example, the global geometry may comprise a curvature and/or a bend. In an example, the deviation map may comprise a deviation map indicating the curvature and/or bend for two or more positions.

In an example, the first target geometry of the wafer and/or die may be based at least in part to the predetermined geometry of the target wafer. As the applying of the plurality of modifications may enable generating a variety of (customizable) first target geometries, the evoked first target geometry can be matched (at least in part) to the predetermined geometry. For example, it may be conceivable that the first target geometry of the wafer and/or at least one die corresponds to a partial area and/or a partial volume of the predetermined geometry of the target wafer.

In an example, the methods described herein may further comprise applying a plurality of local modifications within the target wafer. Notably, since the wafer and the at least one die described herein can be for bonding to the target wafer, the latter may be conditioned as well for facilitating a bonding.

To that regard, every aspect described for the conditioning of the wafer and/or die may be accordingly applied to the conditioning of the target wafer. For example, the applying of the plurality of local modifications within the target wafer may be based at least in part on a characteristic of the wafer and/or at least one die.

Notably, the sequence of applying of the plurality of local modifications within the target wafer may not be necessarily limited. For example, the applying of the plurality of local modifications within the target wafer may occur before, after or during the applying of the local modifications within the wafer and/or the at least one die.

In an example, the applying of the plurality of local modifications with the target wafer evoke a second target geometry of the target wafer.

In an example, the second target geometry may be predetermined such that at least one bonding quality parameter is improved compared to when no conditioning occurs. In an example, the second target geometry may be based at least in part on the first target geometry or vice versa.

For example, the first target geometry may correspond at least in part to the second target geometry (or vice versa). In one example, these may both be substantially flat. In this case at least one of the wafer, the at least one die or the target wafer may have, after application of the local modifications, for example, a comparatively lower bow or warpage than before the applying of the local modifications.

In an example, the first target geometry may be different than the second target geometry such that at least one bonding quality parameter can be improved compared to when no conditioning occurs. It may be conceivable that the bonding can be facilitated by generating a predetermined mismatch for the first and second target geometries such that the bonding quality is improved. This may be due to the high physical and/or chemical stress during bonding wherein a predetermined mismatch may actively induce a facilitation of the bonding of the substrates.

In an example, the methods described herein may comprise sending a target geometry to a device for further processing, particularly a bonding device for bonding the wafer or at least one die to the target wafer. For example, the bonding device may consider the target geometry for bonding. This may enable the bonding device to adapt one or more bonding process parameters based on the target geometry.

In an example, the applying the plurality of local modifications may be adapted such that, when the wafer or the at least one die and the target wafer are arranged in a bonding position, at least one local bonding area of the wafer or die and a corresponding local bonding area of the target wafer have substantially a same curvature. For example, the bonding position may comprise that the local bonding areas are arranged on top of each other. For example, the corresponding bonding areas may comprise opposing and/or adjacent areas of the wafer/die and the target wafer in the bonding position. The bonding position may comprise that at least one intermediate (bonding) material is present between the two substrates.

In an example, the applying the plurality of local modifications within the die and/or its carrier (or the wafer) may be adapted such that, when the die (the wafer) and the target wafer are arranged in a bonding position, a structure of the die (of the wafer) is substantially aligned to a corresponding structure of the target wafer. For example, without the conditioning as described herein, the die and the target wafer may be bent such that when they are positioned in a bonding position, corresponding structures (e.g., to be bonded to each other) may not be substantially aligned. The conditioning described herein may enable an alignment for bonding via the customizable conditioning with a high degree of freedom.

In an example, the applying of the plurality of local modifications may evoke a (predetermined) position correction of least one structure of the wafer and/or die. In other words, it not necessarily related to a shape control. Thus, the aspects described herein may not be limited to a conditioning effect that only adapts a (local or global) bending of the substrate as described herein (e.g., adapting a warp, a bow, a topography, etc.). Also, a second conditioning effect may be evoked that comprises a precise local position correction of at least one structure. This may be enabled, due to the high degree of freedom for the applied pixels, wherein each pixel may induce a freely customizable effect (e.g., via different forces along different axes of the substrate). To that regard a change of the topography (i.e., a first conditioning effect) may be interleaved with a local position correction of a structure (i.e., a second conditioning effect). However, also only a position correction may be implemented as a conditioning.

The at least one structure may comprise a desired process structure (as described herein).

For example, the position correction may comprise an overlay correction. The overlay correction may comprise a pattern-to-pattern alignment error that may result from a lithographic overlay error and/or other pre-processing deviations. Notably, the method may comprise determining (e.g., measuring) the overlay error and/or receiving the overlay error. For example, the method may comprise determining (or receiving) a position of a structure wherein the position may be compared to a target position of the structure. In an example, the position correction may be applied for a plurality of structures, for example, for structures of the entire wafer and/or the entire at least one die to correct the overlay error globally.

In an example, the applying of the plurality of local modifications may comprise applying one or more pulses of electromagnetic radiation to generate the corresponding plurality of local modifications, e.g., within the sample. For example, the electromagnetic radiation may be focused within (or onto) a layer, a substrate, a die, and/or a die carrier to cause local modifications within that element. In an example, a local modification may be evoked in an effective area of a (3-dimensional) focus of the electromagnetic radiation.

The source of the electromagnetic radiation may comprise a laser. The wavelength of the electromagnetic radiation (e.g., a laser wavelength) may comprise a wavelength between 1 µm and 20 µm. In an example, the electromagnetic radiation may comprise a wavelength (preferably) between 1 µm and 15 µm, (preferably) between 1 µm and 12 µm, (preferably) between 1 µm and 8 µm, (preferably) between 1 µm and 3 µm and/or (preferably) between 1 µm and 2 µm.

In an example, the electromagnetic radiation may comprise a wavelength between 1000 nm and 2000 nm. For example, the wavelength may comprise a wavelength of 1060 nm to 1070 nm, e.g. about 1064 nm. In another example, the wavelength may comprise a wavelength of 1530 nm to 1570 nm, e.g. about 1550 nm. In other example, the wavelength may be chosen to be within the range of 1060 nm to 1570 nm.

The pulse duration of one of the one or more pulses of the electromagnetic radiation may comprise a duration between 1 femtosecond (fs) and 100 microseconds (µs). In an example, the pulse duration may comprise a duration between 100 fs and 1 µs, (preferably) between 500 fs and 500 ns, (preferably) between 600 fs and 300 ns, (preferably) between 700 fs and 200 ns, (preferably) between 800 fs and 100 ns.

By adapting one or more optical characteristics of the electromagnetic radiation and/or a focus property thereof, a characteristic of a local modification (i.e., a pixel) may be adapted. The adapting of the electromagnetic radiation may be performed via an optical setup that may optically influence the electromagnetic radiation. For example, the optical setup may comprise one or more optical elements (e.g., such as a lens, a beam shaping element, a wave shaping element, a focusing element, a diffractive optical element, a beam splitter, etc.) that may be controlled to induce a specific characteristic of a pixel. For example, by controlling the properties of the electromagnetic radiation, a local modification parameter of a pixel (e.g., an alignment of the pixel, a magnitude of the first and/or the second force of the pixel) may be precisely controlled.

In an example, a local modification parameter of a pixel may comprise a characteristic of a pixel as described in US 20170010540 (with a pixel being termed therein an expansion area or a deformation, for example). Notably, in Fig. 8 and Fig. 9 of US 20170010540 the concept of a pixel (as, for example, described herein) is shown, indicating the magnitude of the expansion (of the pixel) versus its direction in space.

In an example, US 20170010540 may be regarded as a technology platform for the present invention. The local modifications may be adapted as described therein for a different purpose. Thus, the present invention may comprise using this technology platform to implement the herein described aspects for conditioning a wafer and/or die (e.g., for bonding). For example, the plurality of modifications may be adaptable and/or controllable in a similar fashion as described for US 20170010540. For example, a local modification parameter of a pixel may be adapted by adapting a beam shape of the electromagnetic radiation (e.g., a laser pulse) as described in US 20170010540. In an example, US 20170010540 is incorporated herein in its entirety by reference.

In an example, the method may further comprise performing a calibration, wherein the calibration comprises that the plurality of local modifications is applied within a calibration substrate. The calibration may further comprise determining a characteristic of at least one modification of the plurality of local modifications and/or a geometry of the calibration substrate. Based on these calibration results the applying of the plurality of local modifications may be adapted for implementing the methods as described herein.

In an example, the aspects described herein may be performed before a bonding step. The methods may thus be applied as a pre-conditioning of the bonding, in some examples followed by an actual bonding step to the target wafer. In other examples, they may additionally or alternatively also be applied after a bonding step.

In an example, during the bonding one or more bonding process parameters may be based at least in part on the conditioning (as described herein). This may enable a precise bonding in view of the conditioning according to the invention. For example, during bonding one or more bonding process parameters may be based at least in part on a target geometry.

The wafers as described herein may comprise semiconductor-based wafers (e.g., a wafer comprising a semiconductor, e.g., silicon, gallium nitride, silicon carbide, gallium arsenide, etc.). The wafer may be in a substantially circular shape. In example, the wafer diameter may comprise a diameter between 1 inch and 24 inches. For example, the wafer diameter may comprise a diameter of substantially 300 millimeters (e.g., 12 inch). In another example, the wafer diameter may comprise a diameter of substantially 200 mm (e.g., 8 inch). In another example, the wafer diameter may comprise a diameter of substantially 150 mm (e.g., 6 inch). However, any other wafer dimension may be suitable for the herein described method.

The aspects described herein may be used to facilitate die to wafer and/or wafer to wafer bonding.

In some examples, the methods described herein may include: receiving a second characteristic of a target wafer; and determining a plurality of local modifications to be applied within the wafer, the at least one die, and/or the carrier based at least in part on the second characteristic. The local modifications may for example be determined such as to facilitate bonding between the wafer and/or the at least one die to the target wafer.

The methods may, additionally or alternatively, comprise receiving a first characteristic of the wafer and/or the at least one die. The step of determining the plurality of local modifications may be based at least in part on the first characteristic, e.g., to facilitate bonding.

For example, the determining the plurality of local modifications may comprise the calculation of the pixels and their local modification parameters. It may be performed on a computing unit which may be configured to receive and send data to perform the herein described method.

In some examples, a characteristic of a wafer or a die may comprise a geometry of the wafer or die, respectively (as described herein). In some examples, the plurality of local modifications to be applied are determined such as to evoke a target geometry according to the received characteristic.

Methods as described herein may comprise deriving a first target geometry of the wafer and/or die, e.g. to facilitate bonding to a target wafer, and the plurality of local modifications to be applied may be determined to evoke the first target geometry.

In an example, the method may further comprise determining a plurality of local modifications to be applied to the target wafer to facilitate bonding based at least in part on the first characteristic and/or the second characteristic.

In an example, the method may further comprise deriving a second target geometry of the target wafer to facilitate bonding, wherein the plurality of local modifications to be applied to the target wafer is determined to evoke the second target geometry.

Notably, features described for a certain aspect herein may generally be comprised as a feature of the method according to another aspect, although this may not be mentioned specifically in each instance. For example, the aspects related to adjusting a shape may also be used for conditioning in general.

Another aspect relates to a method for bonding of at least one die to a target wafer, comprising: adapting one or more bonding process parameters based at least in part on a conditioning of the bonding according to a method as described herein.

A still further aspect relates to a method for conditioning at least one die on at least one carrier and/or a wafer, comprising: applying a plurality of local modifications within the die, its carrier, and/or the wafer (e.g. its substrate and/or one or more surface layers thereof, as described herein) based at least in part on a characteristic of a target wafer. In an example, this conditioning may be applied conditioned in view of the target wafer, as it may not always be necessary to condition a substrate in view of another processing (e.g., a bonding). For example, the wafer and/or die may be conditioned in view of a characteristic of the target wafer, e.g., for calibration purposes.

Another aspect relates to a computer program with instructions for performing the methods as described herein, when the computer program is executed. In an example, the computer program may also implement steps to determine the plurality of local modifications to be applied, e.g., as described herein.

A still further aspect relates to a chip. The chip may comprise: a (bonded) die which has been conditioned according to one of the methods as described herein; and/or a (bonded) wafer, having a substrate and at least one surface layer, wherein the shape of the wafer has been adjusted according to one of the methods as described herein.

A further aspect relates to an apparatus for adjusting a shape of a wafer having a substrate and at least one surface layer. The apparatus may comprise: means for applying a plurality of local modifications in the wafer. The apparatus may further comprise: means for adjusting a focus of the means for applying such that a plurality of local modifications is generated within the at least one surface layer; and/or means for adjusting the focus such that a plurality of local modifications is generated within the substrate, via the at least one surface layer.

The apparatus may further comprise a control unit configured to control the apparatus to automatically perform a method as described herein. The control unit may comprise at least one memory in which the instructions of the computer program outlined herein are stored, at least temporarily.

Yet another aspect relates to an apparatus for conditioning dies for bonding, wherein the apparatus comprises: means for applying a plurality of local modifications for facilitating bonding at least one die to a wafer; means for adjusting a focus of the means for applying such that a plurality of local modifications are generated within the at least one die; and/or means for adjusting the focus such that a plurality of local modifications are generated within the at least one carrier.

The apparatus may further comprise a control unit configured to control the apparatus to automatically perform a method as described herein.

The means for applying may comprises a source for generating one or more pulses of electromagnetic radiation. The means for adjusting the focus may comprise a first element for focusing a beam of the electromagnetic radiation onto a predetermined focusing depth.

A control unit as described herein may, for example, comprise a computer, a computing entity, a processor that may adapt one or more system parameters of the apparatus (e.g. system parameters of an optical setup of the apparatus) to cause the apparatus to perform the herein described methods. In an example, the control unit may comprise a storage wherein the storage may comprise the computer program described herein. The apparatus may thus be configured to execute the computer program. This may enable the control unit to control the apparatus to perform a method as described herein.

In an example, the apparatus may comprise means for determining the plurality of local modifications within a substrate for a herein described method. The means for determining may be comprised in a control unit (and may comprise an according computer program).

For example, the means for determining may determine via a simulation and/or a calculation what modification parameter a pixel of the plurality of local modifications should have such that a first target geometry is evoked, wherein the first target geometry may be based on a characteristic of the target wafer. The means for determining may thus also determine a first target geometry via a simulation and/or a calculation in view of, for example, a predetermined geometry and/or position of a structure of the target wafer.

In an example, the control unit may be configured to receive information that the wafer and/or die is for bonding to the target wafer and to control the apparatus to perform the method based at least in part on the information. The information may comprise a trigger signal, a flag and/or a manual input.

In an example, the means for applying may further comprise at least one of the following: a first element for adapting a wavefront of the electromagnetic radiation; means for splitting the beam of electromagnetic radiation into a plurality of split beams.

In an example, the apparatus may further comprise means for positioning a sample (such as the wafer and/or at least one die) to control a local position of at least one local modification of the plurality of local modifications. For example, the positioning may comprise a rotation (via the means for positioning). For example, the sample may be positioned in a first position wherein a first set of local modifications is applied to the sample within a first application field (e.g., within a delimited area or volume corresponding to the sample). Subsequently, the sample may be rotated (e.g., via a rotation of the means for positioning) to a second position where a second set of local modifications is applied within a second application field. Hence, the plurality of local modifications may be distributed/positioned by rotating the sample. This may enable that the positioning of the interactions evoking the local modifications (e.g., a positioning of the optical path of the one or more laser pulse focused into the sample) may be reduced in complexity.

Notably, the means for positioning the sample may not be necessarily limited to a rotation. For example, the means for positioning may position the sample via a lateral movement wherein the lateral movement may be along one or more axes. The lateral movement may be combined with a rotational movement. By enabling a lateral movement in combination with a rotational movement a local modification may be positioned onto (substantially) any position within the sample. In an example, the means for positioning may be adapted to perform a rotation of the sample in combination with a lateral movement thereof along one or more axes wherein the lateral movement may comprise a movement in opposite directions of the axis. Hence, by rotating the sample and a lateral movement sets of the local modifications may be applied within a spiral pattern (as described herein).

In an example, the means for positioning may enable a three-dimensional positioning of the sample within the apparatus. For example, the means for positioning may thus enable a lateral movement (along one or more axes), as well as a vertical movement of the sample within the apparatus.

The herein described lateral movement and/or the rotational movement may comprise a movement of the sample within a plane (that may be spanned or be parallel to the sample surface).

In an example, the means for positioning may be configured to position a bonded wafer-die or wafer-wafer pair. For example, the means for positioning may be adapted to securely clamp a bonded pair. For example, the means for positioning may comprise a chucking system that is capable to securely fixate the bonded pair while a method according to one of the herein described aspects is performed. Namely, a common means for positioning a wafer may not always be suitable to safely position a bonded substrate pair.

In an example, the means for positioning may comprise a chuck and/or a stage. For example, the chuck may be adapted to be in contact with the bonded pair and to securely fixate it. In an example, the chuck may be coupled to the stage to follow its movement, wherein the stage may be adapted to perform a lateral movement, a rotational movement and/or a three-dimensional movement as described herein. In another example, the chuck may perform a lateral movement, a rotational movement and/or a three-dimensional movement as described herein (wherein the stage may follow the movement of the chuck or wherein, for example, no stage is present).

It is noted that the method steps (or computer program steps) as described herein may comprise all aspects described herein, even if not expressly described as method steps but rather with reference to an apparatus (or device or system). Moreover, the apparatus (or systems or devices) as outlined herein may comprise means for implementing all aspects as outlined herein, even if these may rather be described in the context of method steps (or computer program steps).

The methods outlined herein may be computer-implemented.

Whether described as method steps, computer program and/or means, the functions described herein may be implemented in hardware, software, firmware, and/or combinations thereof. If implemented in software/firmware, the functions may be stored on or transmitted as one or more instructions or code on a computer-readable medium. Computer-readable media include both computer storage media and communication media including any medium that facilitates transfer of a computer program from one place to another. A storage medium may be any available media that can be accessed by a general purpose or special purpose computer. By way of example, and not limitation, such computer-readable storage media can comprise RAM, ROM, EEPROM, FPGA, CD/DVD or other optical disk storage, magnetic disk storage or other magnetic storage devices, or any other medium that can be used to carry or store desired program code means in the form of instructions or data structures and that can be accessed by a general-purpose or special-purpose computer, or a general-purpose or special-purpose processor. The control unit as described herein may also be implemented in hardware, software, firmware, and/or combinations thereof, for example, by means of one or more general-purpose or special-purpose computers, and/or a general-purpose or special-purpose processors.

### 4. Short description of the Figures

- **Fig. 1**: shows an example for applying local modifications to a sample for controlling the bending of the sample.
- **Fig. 2**: shows various examples for applying local modifications to a wafer comprising a substrate and at least one surface layer.
- **Fig. 3**: shows an example for applying local modifications within a surface layer of a wafer to control its bending.
- **Fig. 4**: shows various examples for applying local modifications to a die, as well as carriers of the die.
- **Fig. 5**: shows a first example of an exemplary apparatus.
- **Fig. 6**: shows a second example of an exemplary apparatus.
- **Fig. 7**: shows a third example of an exemplary apparatus.

### 5. Detailed description of the Figures and Further Embodiments

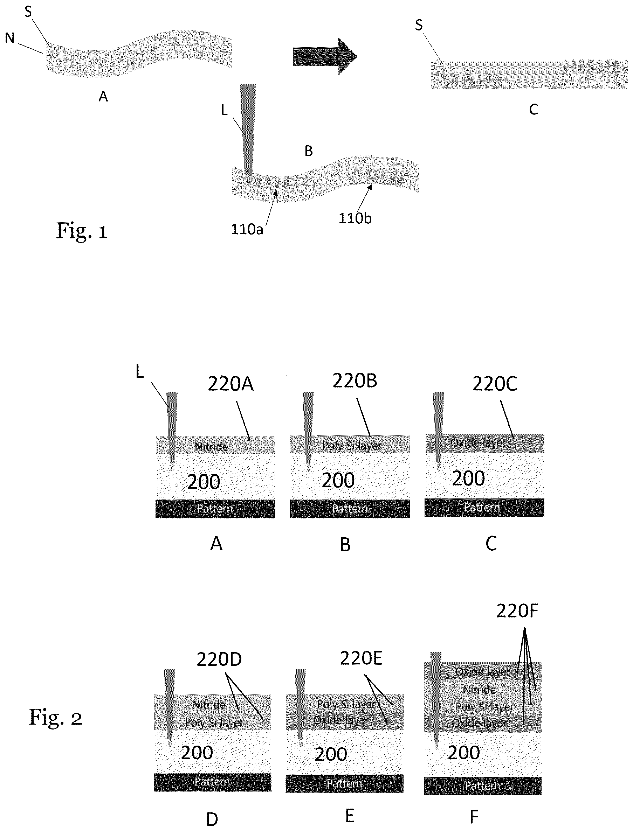

Fig. 1 shows a generic example explaining the general principles underlying the aspects described herein.

At step A, a substrate S is provided which comprises a neutral axis N. The substrate may for example comprise silicon or other materials as described herein.

At step B, a plurality of local modifications 110a and 110b is applied within substrate S by a plurality of laser pulses L. Each local modification 110a and 110b may correspond to a stress element or pixel. The laser pulses may be focused into the substrate S with different focal depths for local modifications 110a and 110b, respectively. When the intensity of a laser pulse exceeds a threshold, a non-linear process may be initiated that leads to a local expansion of the material. By the 3-dimensional focal shape, the expansion can be controlled in 3-dimensions (e.g. x, y, and z directions).

For example, the focus for local modifications 110b may be deeper inside the substrate than for local modifications 110a. Thus, the local modifications 110b are generated deeper inside the substrate. For example, by applying the local modifications 100a (above the neutral axis N of substrate S in Fig. 1), an expansion above the neutral axis N is introduced, counteracting the bend of substrate S at the positions of the local modifications 100a. In turn, by applying the local modifications 100b (below the neutral axis N of substrate S in Fig. 1), an expansion below the neutral axis N is introduced, counteracting again the bend of substrate S at the positions of the local modifications 100b.

At step C, as a result, a substantially flat substrate S can be obtained.

Fig. 2 shows various examples for applying local modifications to a wafer having a substrate 200 and a patterned frontside via one or more surface layers 220A through 220F at its backside, according to the aspects described herein.

The substrate 200 may comprise a silicon substrate that may be crystalline and comprise a thickness of tens to several hundreds of µm. For example, it may comprise a thickness of about 700 µm to 800 µm.

Specifically, at position A, a local modification is applied to the substrate 200 by a laser pulse L via a single surface layer 200A that comprises nitride. In some examples, this may be a SiNₓ layer. For example, the surface layer 200A may comprise a thickness of several tens to several hundreds of nm.

At position B, a local modification is applied to the substrate 200 by a laser pulse L via a single surface layer 200B that comprises polysilicon. For example, the surface layer 200B may comprise a thickness of several tens to several hundreds of nm.

At position C, a local modification is applied to the substrate 200 by a laser pulse L via a single surface layer 200C that comprises oxide. In some examples, the oxide may comprise SiOₓ. For example, the surface layer 200C may comprise a thickness of several tens to several hundreds of nm.

The inventors have found out that, by suitably focusing the laser pulses, local modifications in the substrate 200 can be safely achieved despite first having to go through surface layers 200A through 200C and avoiding having to go through the patterned frontside.

On top of that, the inventors have found out that this may still be accomplished for a plurality of surface layers.

For example, at position D, two surface layers 200D are provided, and a local modification is applied to the substrate 200 by a laser pulse L via the two surface layers 200D. A first one of the surface layers 200D (directly adjacent the substrate 200) comprises polysilicon, and a second one of the surface layers 200D (directly adjacent the polysilicon layer) comprises nitride, such as SiNₓ. Each of the two surface layers may comprise a thickness of several tens to several hundreds of nm.

At position E, two surface layers 200E are provided, and a local modification is applied to the substrate 200 by a laser pulse L via the two surface layers 200E. A first one of the surface layers 200E (directly adjacent the substrate 200) comprises an oxide, such as SiOₓ. A second one of the surface layers 200E (directly adjacent the oxide layer) comprises polysilicon. Each of the two surface layers may comprise a thickness of several tens to several hundreds of nm.

Finally, at position F, four surface layers 200F are provided, and a local modification is applied to the substrate 200 by a laser pulse L via the four surface layers 200F. A first one of the surface layers 200F (directly adjacent the substrate 200) comprises an oxide, such as SiOₓ. A second one of the surface layers 200F (directly adjacent the oxide layer) comprises polysilicon. A third one of the surface layers 200F (directly adjacent the polysilicon layer) comprises nitride, such as SiNₓ. A fourth one of the surface layers 200F comprises an oxide, such as SiOₓ. Each of the four surface layers may comprise a thickness of several tens to several hundreds of nm. For example, a total thickness of the four surface layers 200F may comprise 1 µm to 3 µm, for example.

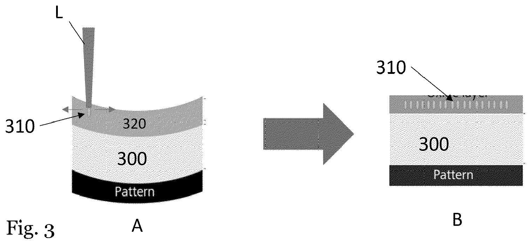

Fig. 3 shows an example for a process in which local modifications are applied within a surface layer 320 on a substrate 300 of a wafer.

At position A, a wafer is provided with a substrate 300, a surface layer 320 at its backside and, e.g. a pattern on its front side. The substrate 300 may comprise a thickness of about 700 µm to 800 µm. The surface layer 320 may for example comprise a thickness of 20 µm to 100 µm. Especially for thicker or thinner substrates 300, also thicker or thinner surface layers 320 may be used.

The substrate 300 may comprise silicon, e.g. crystalline silicon. The surface layer 320 may comprise an oxide (e.g. SiOₓ), polysilicon and/or silicon nitride (e.g. SiNₓ), for example.

As further shown at position A, a plurality of local modifications 310 is introduced into the surface layer by laser L to control its shape.

The effect of the local modifications can be seen at position B. Due to the expansion induced by the local modifications 310, an essentially flat shape of the wafer is achieved.

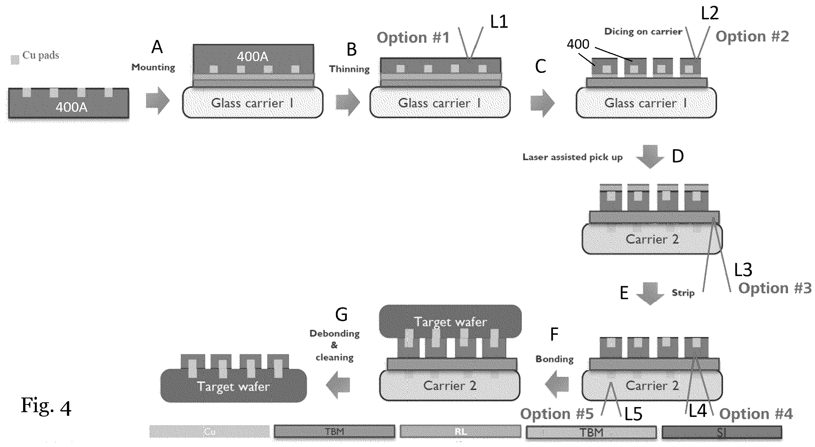

Fig. 4 shows an exemplary flow diagram for a wafer to die bonding process.

First, a wafer 400A is provided. It may comprise a silicon substrate and a plurality of copper pads or other contact elements at its frontside.

In Step A, wafer 400A may be mounted on a carrier. The carrier may comprise a glass carrier 1 and an adhesive layer, e.g. comprising a temporary bonding material, in between the glass carrier 1 and the wafer 400A. In the depicted example, additionally, one layer of protective material is applied to the wafer, e.g. in between the temporary bonding material layer and the wafer. In other examples, other types of carriers and/or protective layers may be used.

In Step B, wafer 400A may be thinned, e.g. by grinding and/or polishing. After this step, wafer 400A may comprise a thickness of about 20 µm to 200 µm, for example, about 30 µm to about 80 µm. In some examples, one or more (protective) surface layers may optionally be deposited on the thinned wafer 400A in Step B.

In a first example, local modifications may be introduced in wafer 400A by applying laser pulses L1 onto the backside of the wafer which may be exposed after Step B and/or which may be covered with one or more surface layers after Step B. These laser pulses may be used to implement aspects described herein with reference to a wafer with at least one surface layer.

Regardless of whether pulses L1 have been applied, in Step C, a dicing process may be applied which separates wafer 400A into a plurality of dies 400.

In a second example, local modifications may be introduced in one or more dies 400 by applying laser pulses L2 onto the backside of the dies 400 which may be exposed after Step C and/or which may (still) be covered with one or more surface layers after Step C. These laser pulses may be used to implement aspects described herein with reference to a die. Notably, applying the laser pulses L2 may allow treating each die individually and thus provide improved or at least simplified control of the shape and/or the conditioning in general.

In Step D, the dies 400 may be removed from glass carrier 1, e.g. by laser-assisted debonding. The dies 400 may be (individually) picked up and placed onto another carrier. The another carrier may comprise a (glass) carrier 2 that may or may not be the same as glass carrier 1, and it may comprise a layer of temporary bonding material between carrier 2 and the dies 400 (carrier 2 may comprise silicon, quartz, glass, etc.). Importantly, however, dies 400 are now attached to the carrier with their backside facing the carrier.

In Step E, dies 400 are cleaned, and in this step the layer of protective material may be removed.

Either after Step D or after Step E, three further examples may be applied (regardless of whether examples 1 or 2 have been applied). In all these examples, local modifications are introduced via the carrier.

In a third example, local modifications may be introduced via carrier 2 into the layer of temporary bonding material. To this end, laser pulses L3 are applied to the backside of the carrier with a suitable focus depth such that local modifications are generated in the layer of temporary bonding material. This may allow an effective control of the shape (and/or an effective conditioning in general) of the dies 400, without having to introduce local modifications into the dies 400 themselves.

In a fourth example, local modifications may be introduced into the dies 400 via their backsides. To this end, laser pulses L4 are applied to the backside of the carrier with a suitable focus depth such that local modifications are generated in the dies 400. This may allow a particularly precise control of the shape and/or conditioning of the dies since the local modifications are close to the decisive frontside of the dies 400.

In a fifth example, local modifications may be introduced into carrier 2. To this end, laser pulses L5 are applied to the backside of the carrier with a suitable focus depth such that local modifications are generated in carrier 2. This may allow an effective control of the shape and/or an effective conditioning in general of the dies 400, without having to introduce local modifications into the dies 400 themselves. Moreover, carriers such as glass, quartz or silicon carriers are typically standardized and have a homogeneous material composition such that applying local modifications may be particularly reproducible and reliable.

It is noted that the above examples one through five may also be combined, at least partly, as needed.

In Step F, the actual bonding of the dies 400 to a target wafer may be carried out. By suitably conditioning the dies 400 (and optionally of the target wafer), such as controlling their shape (and optionally that of the target wafer), for example inhomogeneous bonding areas and/or air bubbles in the bonding region may be avoided.

In Step G, the bonded target wafer/die pair is debonded from the carrier and cleaned. Optionally, a final anneal may be performed.

It is noted that the aspects described herein with respect to controlling the shape of wafers, and with respect to conditioning for bonding of dies may generally be applied to wafers, dies, chips, etc. also after bonding, e.g. to facilitate additional bonding steps, to make further corrections, etc.

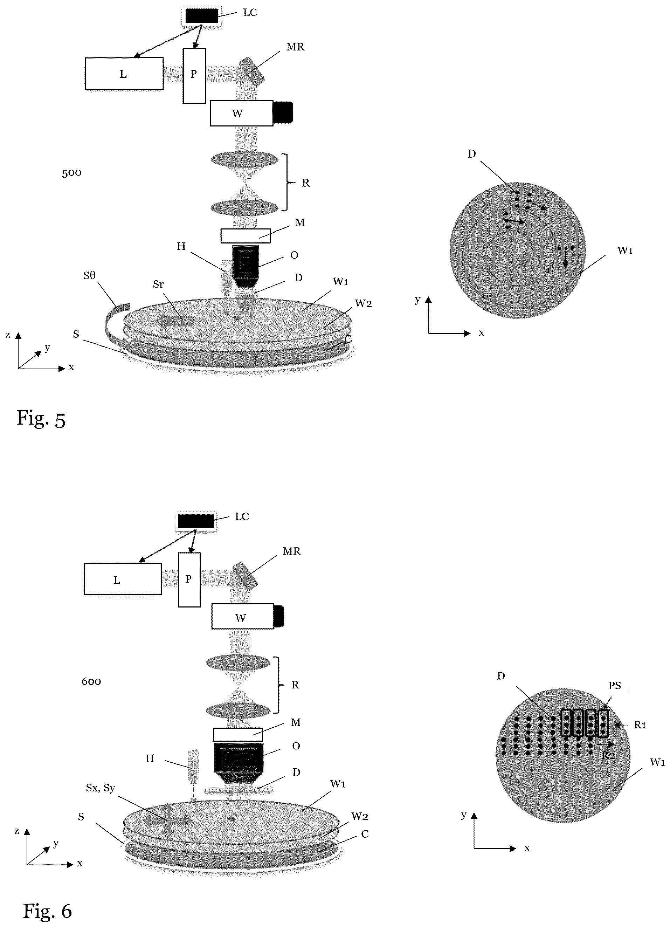

Fig. 5 shows a first example of an apparatus 500 according to the invention. The apparatus may be configured to perform a herein described method. The main principle of the apparatus is that a laser beam is focused within a sample (e.g. substrate, wafer, die, chip, etc.) such that a local reaction is evoked that causes a defined local modification (i.e., a pixel).

The apparatus 500 may comprise a laser unit L. The laser unit L may comprise a laser that may be controlled to output laser pulses along a laser beam direction. The laser may comprise a laser with a herein described wavelength. Notably, the laser may also comprise any other type of laser in the infrared range (e.g., with a wavelength between 700 nm and 50 µm).

In an example, the laser energy may comprise an energy between 1 µJ and 100 µJ. In an example, the laser power may comprise a power between 40 W and 200 W.

The apparatus 500 may further comprise a pixel modulator P. The pixel modulator P may comprise an acousto-optic modulator. The pixel modulator P may modulate whether the incoming laser beam from the laser unit L is coupled into the main beam path of the apparatus. For example, the pixel modulator P may guide the incoming laser beam such that it is not coupled to the main optical path of the apparatus. In an example, the pixel modulator P may evoke a blanking of the incoming laser beam such that the laser beam is not coupled to the main beam path (e.g., via an absorption of the laser beam light). The pixel modulator P may enable a control whether a laser beam focus that evokes a pixel within the sample is applied to the sample or not. The laser unit L and the pixel modulator P may be controlled via a laser control unit LC. The laser control unit LC may comprise a laser gate control unit.

Subsequently, optical elements along the main optical path of the laser are explained that may be controlled in a purposeful manner to adapt a local modification parameter of a pixel within a sample.

In an example, the main optical path may comprise a deflecting mirror MR to deflect the laser beam coming from the pixel modulator P (e.g., for spatial design purposes).

The main path may further comprise a waveform manipulator W. The waveform manipulator W may be controllable to adapt the shape of the waveform of the laser beam wavefront. In an example, the waveform manipulator may be controllable to induce a desired astigmatism of the laser beam. For example, the waveform manipulator W may be controllable to induce an astigmatism along a certain orientation. This may enable the adapt the orientation of the pixels (as described herein). The waveform manipulator W may, for example, comprise a spatial light modulator (SLM). The spatial light modulator may comprise a liquid crystal on silicon (LCoS SLM). In an example, the waveform manipulator W may comprise an optical unit that may adapt the waveform of the laser beam (e.g., by inducing a desired astigmatism). In an example, the waveform manipulator W may comprise a waveform control unit (wherein the waveform control unit may comprise a motor to adapt the waveform manipulator).

The optical path may further comprise a relay unit R. The relay unit R may comprise two or more lenses. The relay unit R may be configured to function as telescope. For example, a focus of a first lens of the relay unit R may be positioned within a focus of a second lens of the relay unit R.

The optical path may further comprise a multi beam unit M. The multi beam unit M may function to generate two or more partial beams out of the incoming laser beam. For example, the multi beam unit M may comprise a diffractive optical element (DOE). The diffractive optical element may comprise a diffraction grating. The diffraction grating may comprise a transmissive and/or reflective grating. In an example, the multi beam unit M may comprise a wavefront manipulator (e.g., a spatial light modulator). In an example, the multi beam unit M and the wavefront manipulator W may be realized via one optical element (e.g., a wavefront manipulator in the form of a spatial light modulator). In the example, of Fig. 5, the multi beam unit M is adapted to generate three spatially separated beams out of the incoming laser beam. Hence, three focus points may be generated within the processed sample (as indicated in Fig. 5) for one laser shot. In turn, a set of three pixels may thus be applied simultaneously in this example. A shot may comprise one or more laser pulses coming out of the laser unit L such that enough energy/power is applied within the sample to generate at least one pixel. The multi beam unit M may be configured to generate at least four partial beams (thus 4 pixels with one shot), at least 8 partial beams (thus 8 pixels with one shot), at least 10 partial beams (thus 10 pixels) with one shot. It may also be conceivable the generate up to 100, 200, 300 and/or 500 pixels within one shot.

In another example, the multi beam unit M may function to scan the incoming laser beam onto predetermined scan positions within the sample. For example, the multi beam unit M may comprise a scanning unit (e.g., an acousto-optic deflector, AOD, a spatial light modulator, a galvanometer scanner, etc.). To illustrate an example, the multi beam unit may be configured to deflect the incoming laser beam onto three predetermined scan positions within the sample. This may enable to evoke three local modifications within a spatial area/volume of the sample within a scan window time. For example, the scanning unit may deflect the incoming laser beam onto a first scan position. Subsequently, a first pixel may be written onto the first scan position. Thereafter, the scanning unit may deflect the incoming laser beam to a second scan position. Subsequently, a second pixel may be written onto the second scan position. This may be repeated for the third scan position. The scan window time may comprise the time in which the entire processing for the first, second and third scan position has occurred.

Pixel modulator P, deflecting mirror MR, wavefront manipulator W, relay unit R, and multi beam unit M may all be part of the means for applying local modifications. Laser unit L and laser control unit LC may form a source for generating pulses.

The optical path may further comprise means for adjusting a focus, which may comprise a focusing unit O. The focusing unit O may comprise a telecentric lens unit. However, any other suitable optics may be used as a focusing unit O, including a plurality of lenses. The focusing unit O may be moveable (e.g., via a mechanical stage) to adapt a focusing depth of the laser beam. Hence, the focusing unit O may be used to focus the laser beam onto a predetermined focusing depth within the sample. The optical unit O may be configured such that the optical quality of the laser beam is minimized for a predetermined system focusing depth within the sample (e.g., if no further compensation is made to the laser beam and/or its wavefront). For example, the optical quality may comprise a root-mean-square (RMS) wavefront error.

The optical path may further comprise a depth compensation unit D which may be provided as a part of the means for applying the local modifications. The depth compensation unit D may be controllable to compensate an undesired optical effect that may arise from focusing the laser beam onto a focusing depth different from the predetermined system focusing depth. The depth compensation unit D may comprise a wavefront manipulator. The depth compensation unit D may comprise an optical medium. The optical medium may be positioned via the apparatus (e.g., along the main optical paths optical axis) for a depth compensation. In another example, the apparatus may control the refractive index of the optical medium.

In an example, the depth compensation unit D may be comprised by the wavefront manipulator W. Hence, the wavefront manipulator may implement the depth correction (e.g., via shaping the wavefront).

Furthermore, the apparatus 500 may comprise a height sensor H. The height sensor may measure the height from a reference point to the (upper) surface of the sample which is processed in the apparatus. The height may correspond to a distance parallel to the optical axis of the optical main path of the apparatus. For example, the height sensor may measure a distance between the focusing unit O and the (upper) surface of the sample). The apparatus may be configured to receive the height from the height sensor H and adapt a focusing of the laser beam accordingly.

Moreover, the apparatus 500 may comprise a stage S. The stage S may be configured to secure a (e.g., removable) chuck C. The chuck C may be configured to securely hold a sample (e.g., a wafer). In another example, the chuck may be configured to securely hold a bonded sample pair (e.g., a bonded wafer pair) and/or a carrier for dies. In Fig. 5 a first wafer W1 is shown that is bonded to a second wafer W2 wherein the chuck C may securely hold the bonded wafer pair. One wafer chucking is also possible.

The chuck C may comprise an electrostatic chuck, a vacuum chuck and/or a combination thereof. The chuck C may also comprise a contactless chuck, a side grip chuck (or combinations thereof). Furthermore, the chuck C may also be a transparent chuck. The stage S and the chuck C may be coupled such that they form a positioning unit. Hence, if the stage S moves the chuck C moves accordingly (and/or vice versa). Moreover, if the positioning unit also moves the sample and/or the bonded sample pair secured by the chuck C will move accordingly.

For example, the exemplary apparatus 500 may be configured to rotate the stage S such that the chuck C rotates to accordingly enable a rotational movement Sθ of the sample and/or bonded sample pair secured by the chuck C. For example, the stage S may comprise a R-Theta stage. The R-Theta stage may be configured for a rotational speed between 1000 rpm and 8000 rpm, preferably between 2000 rpm and 6000 rpm, more preferably between 2500 rpm and 5000 rpm, most preferably between 3000 rpm and 4000 rpm. This may enable a high throughput when processing the sample according to the invention.

Moreover, the exemplary apparatus 500 may be configured such that the positioning unit (comprising stage S and chuck C) may be moved back and forth along a lateral axis. This may enable a lateral movement Sr of the sample and/or bonded sample pair secured by the chuck back and forth along the lateral axis.

The rotational movement Sθ and lateral movement Sr may enable to apply the plurality of local modifications in a spiral pattern within a sample. A method as described herein, may thus be performed simply via a rotational movement and a lateral movement (back and forth along one axis) of the sample which may reduce system complexity.

The spiral pattern application enabled by the configuration of the positioning unit is shown on the right subfigure of Fig. 5. An exemplary method is shown, wherein the apparatus 500 applies local modifications D within the first wafer W1. As stated in an example, the apparatus 500 may apply a set of three pixels (i.e., three local modifications D) simultaneously. Via the rotational movement Sθ a plurality of sets of pixels may thus be applied circumferentially along a radius the first wafer W1. Via the lateral movement Sr radius onto which the sets of pixels are applied may be varied. Notably, via the lateral movement Sr the sets of pixels may be applied in a spiral pattern as is visualized in Fig. 5.

Notably, in an example, the positioning unit (stage S and chuck C) of the apparatus 500 may be also configured for a lateral movement along two or more lateral axes (e.g., along the indicated x- and y-axis). In another example, the positioning unit may also be configured for a vertical movement (e.g., along the optical axis of the apparatus). Regardless of the configuration of the positioning unit the apparatus may be configured to only activate the capabilities of the rotational movement and/or the lateral movement to perform the mentioned spiral pattern application. In other examples, also the optical elements may be movable to provide for the mentioned relative movements. For example, an objective may be moved laterally while the stage with the sample or wafer is rotating.

Fig. 6 shows a second example of an apparatus 600 according to the invention. The apparatus may be configured to perform a herein described method. Every aspect/feature described for the apparatus 500 (of the first example) may be applied to the apparatus 600 of the second example. For example, the apparatus 600 may comprise all the features described for the apparatus 500.

However, in the illustrated example of the apparatus 600 of Fig. 6 the positioning unit comprising the stage S and the chuck C may be configured such that a movement along two or more lateral axes may be evoked for the sample and/or sample pair. In an example, the positioning unit may be configured for a lateral movement along an x-axis (Sx) and a lateral movement along a y-axis (Sy) wherein the y-axis may be orthogonal to the x-axis. In the shown exemplary apparatus 600 the multi beam unit M may be an optical element that functions to generate three partial beams (simultaneously) out of the incoming laser beam. (For example, the multi beam unit M of the apparatus 600 may comprise a beam splitter, e.g., a DOE.) Hence, the apparatus may be configured to apply a pixel set PS of three pixels simultaneously within a sample.

By controlling the stage S along the x-axis and the y-axis a plurality of pixel sets PS may be arranged next to each other (e.g., in a rectangular pattern) over the entire sample (e.g., within a first wafer W1 as shown). The right subfigure of Fig. 6 shows an arrangement of various pixel sets PS having each three pixels applied to the first wafer W1. The pixel sets PS may be applied in a line scanning manner. For example, starting from a sample edge the pixel sets may be applied in a line along direction R1 (parallel to the x-axis) until the other end/edge of the sample is reached. Subsequently, the stage may be offset along the y-axis to enable generating the pixels sets on another line along a direction R2 (parallel to the x-axis). This may be repeated to generate pixels over the entire sample.

Notably, every feature described for the apparatus 600 may also be comprised by the apparatus 500 of the first example.

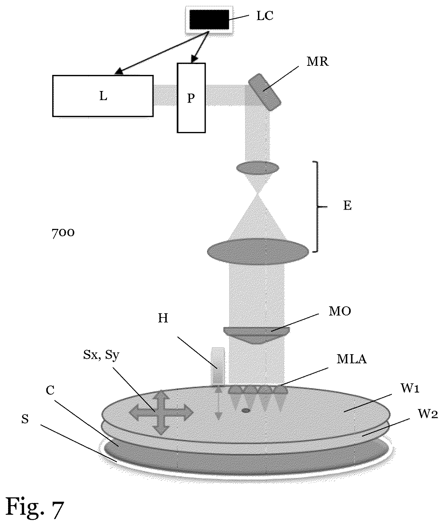

Fig. 7 shows a third example of an apparatus 700 according to the invention. The apparatus may be configured to perform a herein described method. The optical setup of the apparatus may also comprise a laser unit L, a pixel modulator P, a laser control unit LC and a deflective mirror MR arranged within an optical path of the laser beam just as the apparatus 600 and apparatus 500. The apparatus 700 may also comprise a stage S and a chuck C. The apparatus 700 may be configured to control the stage s (and thus the sample secured on the chuck C) as described for apparatus 600 (and/or apparatus 500).

However, the further optics and/or optical elements of the apparatus 700 may differ.

For example, the optical main path of the apparatus 700 may comprise a beam expander E (as shown in Fig. 7). The beam expander E may comprise two lenses. The two lenses may be arranged such that a focus of a first lens is positioned within a focus of a second lens of the beam expander. The lenses may have further optical characteristics or elements such that the incoming laser beam is expanded (and preferably collimated) at the output of the beam expander.

The optical main path of the apparatus 700 may further comprise a micro lens array MLA. The incoming (e.g., expanded) laser beam may be adapted by the micro lens array MLA such that multiple foci can be generated within a sample that is positioned within the apparatus. In the example, of the apparatus 700 the micro lens array MLA comprises a one-dimensional micro lens array having four micro lenses arranged along a line. However, the number of micro lenses of the micro lens array may not be limited according to the invention. In another example, the micro lens array MLA comprises a two-dimensional micro lens array. Hence, this may enable generating multiple foci simultaneously along a focusing plane within the sample.

In an example, the two-dimensional micro lens may be configured such that its according foci substantially cover the entire sample. For example, the sample may be processed within one shot (as all pixels to be applied to the sample may be induced simultaneously). In another, example, the apparatus 700 may comprise a scanning unit for deflecting the laser beam onto one or more micro lenses of the micro lens array MLA. Hence, a subset of the possible foci of the micro lens array MLA may be generated within one shot.

The optical main path of the apparatus 700 may further comprise a micro lens coupling unit MO. For example, if the micro lens array MLA comprises a one-dimensional micro lens array the micro lens coupling unit MO may comprise a Powell lens. The Powell lens may be configured to fan out the incoming laser beam such that a coupling thereof to the one-dimensional micro lens array can be facilitated.

For example, if the micro lens array MLA is a two-dimensional micro lens array the micro lens coupling unit MO may comprise a collimator lens. The collimator lens may be configured such that the laser beam is coupled to the two-dimensional micro lens array (or a subset of micro lenses thereof) in a defined manner.

In an example, the apparatus 700 may also comprise a wavefront manipulator W, a multi beam generator M, and/or a depth compensation unit (as outlined for apparatus 500 and apparatus 600).

Notably, an apparatus according to the invention may be configured such that a total writing time of the pixels over the entire sample is below 30 s, preferably below 20 s, more preferably below 15 s, most preferably below 12 s. This may be enabled by the herein described parallel approaches where pixels may be generated simultaneously.

In an example, the herein described apparatuses (and/or their focusing unit O and/or the micro lens coupling unit MO) may have a numerical aperture within a range of 0.35 to 0.85, or within a range of 0.55 and 0.85.

Notably, an apparatus according to the invention may comprise a control unit (as described herein) for enabling a precise control of its components (e.g., optical elements) for performing a herein described method.

For generating local modifications, in general the geometric shape of the pulse focus, e.g. its corresponding numerical aperture, the pulse energy and the pulse duration are decisive control parameters.

In the following further examples of the invention are described.

Example 1: Method for conditioning a bonding of substrates comprising:
applying a plurality of local modifications within a first substrate for facilitating bonding the first substrate to a second substrate.

Example 2: Method according to example 1, wherein the applying of the plurality of local modifications within the first substrate is further based at least in part on a characteristic of the second substrate and/or of the first substrate.

Example 3: Method according to example 1 or 2, wherein at least one substrate comprises one or more desired process structures.

Example 4: Method according to any of examples 1-3, wherein the applying of the plurality of local modifications within the first substrate is adapted to evoke a first target geometry of the first substrate.

Example 5: Method according to example 4, wherein the first target geometry is predetermined such that if the first and second substrate are bonded, at least one bonding quality parameter is improved compared to when no conditioning occurs.

Example 6: Method according to examples 4 or 5, wherein the first target geometry is based at least in part on a predetermined geometry of the second substrate.

Example 7: Method according to example 6, wherein the predetermined geometry of the second substrate comprises a global geometry of the second substrate.

Example 8: Method according to example 7, wherein the global geometry of the second substrate comprises a surface topography and/or one or more deviations of the second substrate from a substrate reference plane.

Example 9: Method according to any of examples 1-8, further comprising applying a plurality of local modifications within the second substrate.

Example 10: Method according to example 9, wherein the applying of the plurality of local modifications within the second substrate is adapted to evoke a second target geometry of the second substrate.

Example 11: Method according to example 10, wherein the second target geometry is predetermined such that if the first and second substrate are bonded, at least one bonding quality parameter is improved compared to when no conditioning occurs.

Example 12: Method according to example 10 or 11, referred back to any of examples 3-7, wherein the second target geometry is based at least in part on the first target geometry or vice versa.

Example 13: Method according to any of examples 4-12, further comprising sending a target geometry of at least one of the substrates to a device for further processing of at least one of the substrates, particularly a bonding device for bonding first and second substrates.

Example 14: Method according to any of examples 1-13, wherein the applying the plurality of local modifications within the first and/or second substrate is adapted such that, when the first and second substrates are arranged in a bonding position, at least one local bonding area of the first substrate and a corresponding local bonding area of the second substrate have substantially a same curvature.

Example15: Method according to any of examples 1-14, wherein the applying the plurality of local modifications within the first and/or second substrate is adapted such that, when the first and second substrates are arranged in a bonding position, a structure of the first substrate is substantially aligned to a corresponding structure of the second substrate.

Example 16: Method according to any of examples 1-15, wherein the applying the plurality of local modifications within the first substrate is adapted to evoke a position correction of least one structure of the first substrate.

Example 17: Method according to any of examples 1-16, wherein the applying the plurality of local modifications comprises applying one or more pulses of electromagnetic radiation to the corresponding substrate to cause the corresponding plurality of local modifications within that substrate.

Example 18: Method according to any of examples 1-17, wherein the conditioning is performed before the bonding of the first and second substrates occurs.

Example 19: Method according to any of examples 1-18, wherein the conditioning is performed after the bonding of the first and second substrates has occurred.

Example 20: Method according to any of examples 1-19, further comprising the step of bonding the first and second substrates.

Example 21: Method for conditioning a first substrate, the method comprising: receiving a second characteristic of a second substrate;
determining a plurality of local modifications to be applied within the first substrate based at least in part on the second characteristic.

Example 22: The method of example 21, further comprising:
receiving a first characteristic of the first substrate;
determining the plurality of local modifications to be applied within the first substrate to facilitate bonding of the first and second substrates based at least in part on the first characteristic and the second characteristic.

Example 23: Method according to example 21 or 22, further comprising deriving a first target geometry of the first substrate to facilitate bonding of the first and second substrates,
wherein the plurality of local modifications to be applied within the first substrate are determined to evoke the first target geometry for the first substrate.

Example 24: Method according to any of examples 21-23, further comprising deriving a second target geometry of the second substrate to facilitate bonding of the first and second substrates,
wherein the plurality of local modifications to be applied within the second substrate are determined to evoke the second target geometry for the second substrate.

Example 25: Computer program comprising instructions for performing the method according to any of the examples 1-24, when the computer program is executed.

Example 26: Apparatus for conditioning a bonding of substrates comprising:
means for applying a plurality of local modifications within a first substrate for facilitating bonding of the first substrate to a second substrate;
a control unit configured to control the apparatus to perform a method of any of examples 1-24.

Example 27: Apparatus according to example 26, wherein the control unit is configured to receive information that the first substrate is for bonding to the second substrate and to control the apparatus to perform the method based at least in part on the information.

Example 28: Apparatus according to example 26 or 27, wherein the means for applying comprises:
a source for generating one or more pulses of electromagnetic radiation;
a first element for focusing a beam of the electromagnetic radiation onto a predetermined focusing depth within the first substrate.

Example 29: Apparatus according to any of examples 26-28, wherein the apparatus further comprises means for positioning the first substrate to control a local position of at least one local modification of the plurality of local modifications wherein the positioning comprises a rotation of the first substrate.

Example 30: Apparatus according to example 29, wherein the means for positioning is configured to position a bonded substrate pair comprising the first substrate being bonded to the second substrate.

Example 31: Apparatus for conditioning a first substrate, the apparatus comprising: means for receiving a second characteristic of a second substrate;
means for determining a plurality of local modifications to be applied within the first substrate based at least in part on the second characteristic.

Example 32: Apparatus according to any of examples 26-31, further comprising a memory storing the computer program of example 25.

## Claims

1. Method for adjusting a shape of a wafer and/or die having a substrate and at least one surface layer, the method comprising:
applying a plurality of local modifications in the wafer and/or die;
wherein applying the plurality of local modifications comprises:
applying a plurality of local modifications within the at least one surface layer; and/or
applying a plurality of local modifications within the substrate, via the at least one surface layer.

2. Method of claim 1, wherein the at least one surface layer and/or the substrate comprise silicon.

3. Method of claim 1 or 2, wherein the at least one surface layer comprises SiOₓ, polysilicon and/or SiNₓ.

4. Method of any one of claims 1-3, wherein the at least one surface layer is arranged at a backside of the wafer and/or die.

5. Method of any one of claims 1-4, wherein the at least one surface layer is arranged at a side of the wafer and/or die that is opposite to a patterned side of the wafer and/or die.

6. Method according to any one of claims 1-5, wherein the wafer and/or die comprises one or more desired process structures.

7. Method of any one of claims 1-6, wherein the applying a plurality of local modifications within the at least one surface layer comprises applying a plurality of local modifications within at least one surface layer comprising a thickness of at least 8 µm and of at most 250 µm, preferably of at most 100 µm.

8. Method of any one of claims 1-7, wherein the substrate comprises a thickness of at least 250 µm and at most 1500 µm, preferably at most 1000 µm.

9. Method according to any one of claims 1-8, wherein the plurality of modifications is adapted:
for rendering the wafer and/or die substantially flat; and/or
for facilitating bonding the wafer and/or die to a further wafer.

10. Method for conditioning dies for bonding, the method comprising:
providing at least one die on at least one carrier;
applying a plurality of local modifications for facilitating bonding the at least one die to a wafer;
wherein applying the plurality of local modifications comprises:
applying a plurality of local modifications within the at least one die; and/or
applying a plurality of local modifications within the at least one carrier.

11. Method according to claim 10, wherein the applying a plurality of local modifications within the at least one die comprises applying a plurality of local modifications via a backside of the at least one die.

12. Method according to claim 10 or 11, wherein the applying a plurality of local modifications within the at least one die comprises applying a plurality of local modifications via the at least one carrier.

13. Method according to any one of claims 10-12, wherein the at least one carrier comprises at least one of: a glass-based carrier, a quartz-based carrier, a silicon-based carrier, an adhesive layer.

14. Method according to any one of claims 10-13, wherein the plurality of local modifications is adapted such that the at least one die forms a substantially convex surface for facilitating bonding the at least one die to the wafer.

15. Method according to claim 9-14, wherein the plurality of local modifications is adapted such that at least one bonding quality parameter is improved compared to when no modifications are applied.

16. Method according to any of claims 1-15, wherein the applying the plurality of local modifications comprises applying one or more pulses of electromagnetic radiation to generate the local modifications.

17. Computer program comprising instructions for performing the method according to any one of the claims 1-16, when the computer program is executed.

18. A chip, comprising:
a bonded die which has been conditioned according to one of the methods of claims 10-16; and/or
a wafer and/or a die, having a substrate and at least one surface layer, wherein the shape of the wafer and/or die has been adjusted according to one of the methods of claims 1-9.

19. Apparatus for adjusting a shape of a wafer and/or die having a substrate and at least one surface layer, the apparatus comprising:
means for applying a plurality of local modifications in the wafer and/or die;
means for adjusting a focus of the means for applying such that a plurality of local modifications is generated within the at least one surface layer;
means for adjusting the focus such that a plurality of local modifications is generated within the substrate, via the at least one surface layer.

20. Apparatus for conditioning dies for bonding, the apparatus comprising:
means for applying a plurality of local modifications for facilitating bonding at least one die to a wafer;
means for adjusting a focus of the means for applying such that a plurality of local modifications is generated within the at least one die;
means for adjusting the focus such that a plurality of local modifications is generated within the at least one carrier.

21. Apparatus according to claim 19 or 20, further comprising a control unit configured to control the apparatus to perform a method of any one of claims 1-16.

22. Apparatus according to any of claims 19-21, wherein the means for applying comprises:
a source for generating one or more pulses of electromagnetic radiation;
and the means for adjusting the focus comprise a first element for focusing a beam of the electromagnetic radiation into a predetermined focusing depth.
